# EUROPEAN PATENT APPLICATION

(11) **EP 2 696 371 A2**
(43) Date of publication of application: **12.02.2014**
(21) Application number: 13161575.9
(22) Date of filing: 28.03.2013
(51) Int. Cl.: H01L 31/0224

(54) **Solar cell and manufacturing method thereof**

(30) Priority: 09.08.2012 US 201261681303 P; 15.03.2013 US 201313844074
(71) Applicant: Samsung SDI Co., Ltd., Gyeonggi-do 446-557 (KR)
(72) Inventor: Lee, Hee-Yong, Gyeonggi-do (KR)
(74) Representative: Mounteney, Simon James

(57) **Abstract**

The present invention relates generally to a solar cell and a manufacturing method thereof and particularly to a solar cell comprising a substrate and a rear electrode provided on the substrate, wherein the rear electrode comprises n+1 metal columnar grain layers comprising molybdenum (Mo) where 1≤n≤10.

## Description

### BACKGROUND

### 1. Field

The described technology relates generally to a solar cell and a manufacturing method thereof.

### 2. Description of the Related Art

A solar cell is a photoelectric conversion device that converts solar light energy into electrical energy. The solar cell includes a rear-surface electrode layer formed on a substrate, a light absorbing layer provided thereon, and a transparent electrode layer.

The solar cell is classified into a silicon solar cell using silicon as a light absorption layer (or a photoelectric conversion layer), a compound semiconductor solar cell using compounds such as CIS (Cu, In, Se) or CIGS (Cu, In, Ga, Se), and the like.

Among them, regarding the compound semiconductor solar cell, an alkali metal (e.g., sodium) can be included in the light absorbing layer so as to increase efficiency of the light absorbing layer, and many studies relating to this have been undertaken. For example, a compound including an alkali metal can be directly added, or an alkali metal included in the substrate can be spread to the light absorbing layer.

Particularly, methods for spreading the alkali metal in the substrate to the light absorbing layer through the rear electrode layer have been studied, which causes problems such as adherence between the rear electrode layer and the substrate, complexity of the process, and control of an alkali metal concentration.

The above information disclosed in this Background section is only for enhancement of understanding of the background of the described technology and therefore it may contain information that does not form the prior art that is already known in this country to a person of ordinary skill in the art.

### SUMMARY

The present invention provides a solar cell as claimed in any of claims 1 to 12 and a method for producing said solar cell as claimed in claim 13.

The described technology has been made in an effort to provide a solar cell for controlling an alkali metal spread through a rear electrode layer and providing excellent adherence to a substrate through a simple and easy process, and a manufacturing method thereof.

According to an embodiment, the method for manufacturing a solar cell can include oxygen atoms in the rear electrode layer through a simple and easy process, and can efficiently spread the alkali metal into the light absorbing layer by using the oxygen atoms. Also, according to the present embodiment, a solar cell with excellent adherence between the substrate and the rear electrode layer can be acquired.

### BRIEF DESCRIPTION OF THE DRAWINGS

FIG. 1 shows a cross-sectional view of a solar cell according to an embodiment.
FIG. 2 shows an enlarged view of a part II in a solar cell shown in FIG. 1.
FIG. 3A to 3C show a method for manufacturing a rear electrode layer according to an embodiment.
FIG. 4 shows a graph for showing an atom ratio with respect to a thickness measured by X-ray photoelectron spectroscopy (XPS) of the rear electrode layer according to an embodiment.
FIG. 5A and FIG. 5B show photographs of a cross-section of a rear electrode layer captured by a scanning electron microscope (SEM) according to an embodiment and a comparative example.
FIG. 6 shows a graph of results of a peel strength test according to an embodiment and a comparative example.

### DETAILED DESCRIPTION

The present invention will be described more fully hereinafter with reference to the accompanying drawings, in which embodiments of the invention are shown. As those skilled in the art would realize, the described embodiments may be modified in various different ways, all without departing from the spirit or scope of the present invention.

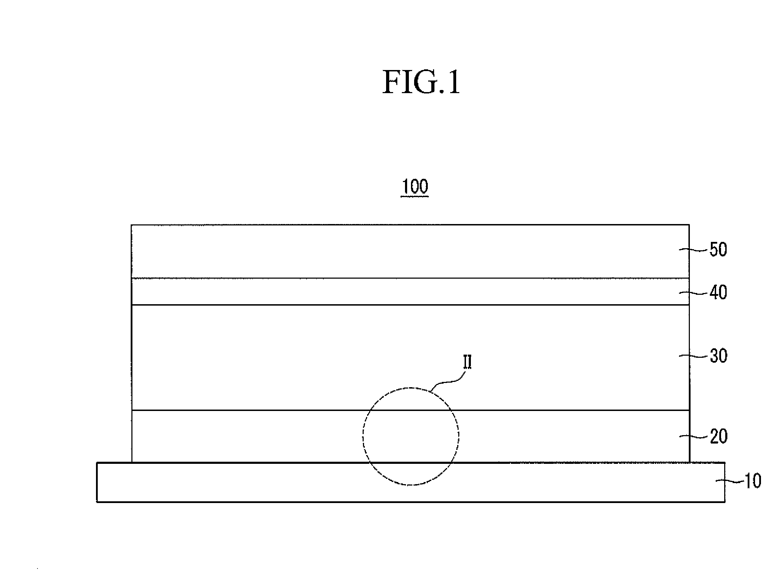

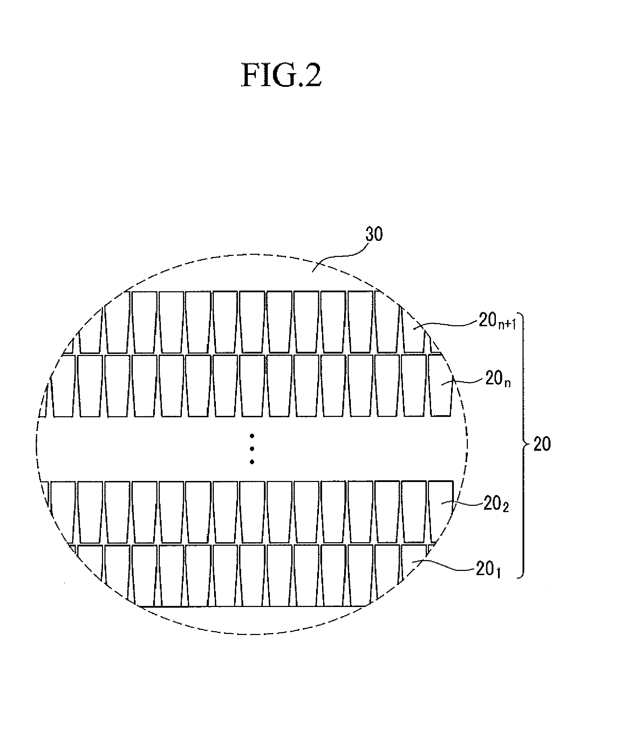

FIG. 1 shows a cross-sectional view of a solar cell according to an embodiment, and FIG. 2 shows an enlarged view of a part II in a solar cell shown in FIG. 1.

Referring to FIG. 1 and FIG. 2, the solar cell 100 includes a substrate 10, a rear electrode layer 20, a light absorbing layer 30, a buffer layer 40, and a transparent electrode layer 50.

In an embodiment of the present invention, the solar cell 100 can be a silicon solar cell using silicon for the light absorbing layer 30, or a compound semiconductor solar cell including CIS (Cu, In, Se) or CIGS (Cu, In, Ga, Se) for the light absorbing layer 30. The light absorbing layer 30 including the CIS or the CIGS will be exemplified hereinafter.

In an embodiment of the present invention, the substrate 10 is provided at the outermost side of the solar cell 100. That is, the substrate 10 is provided farthest from the side on which the sunlight is applied. In an embodiment of the present invention, the substrate 10 can be formed with various materials including plate-type glass, ceramic, stainless steel, metal, or film-type polymers.

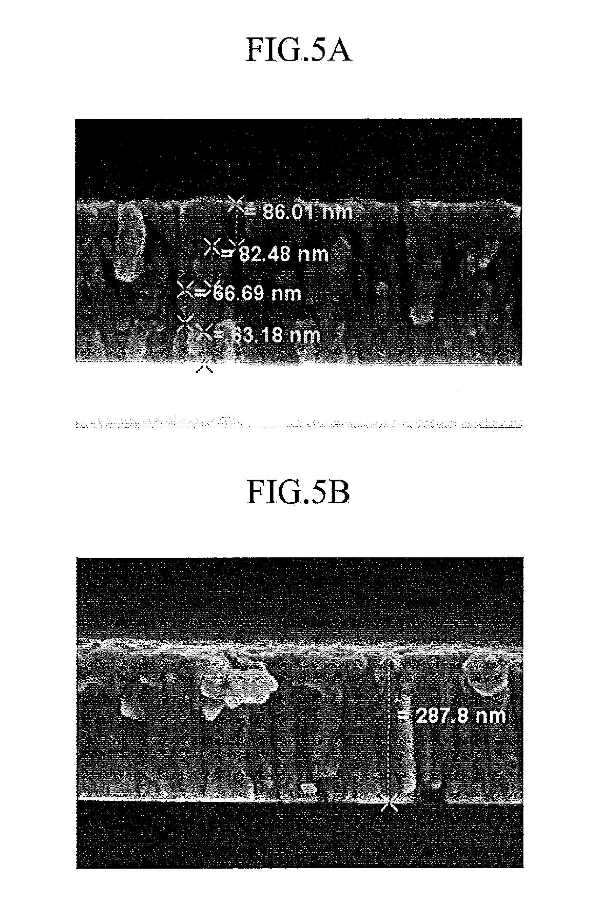

The rear electrode layer 20 is provided on the substrate 10. The rear electrode layer 20 is made of a metal with excellent optical reflective efficiency and adhesion to the substrate 10. For example, the rear electrode layer 20 may include molybdenum (Mo). In an embodiment of the present invention the rear electrode contains elemental molybdenum (Mo). The molybdenum (Mo) has high electrical conductivity, forms an ohmic contact with the light absorbing layer 30, and realizes great stability during a high temperature heat treatment for forming the light absorbing layer 30. The case in which the rear electrode layer 20 is made of molybdenum (Mo) will be exemplified hereinafter. In an embodiment of the present invention the rear electrode comprises at least two layers of columnar grains that comprise molybdenum (Mo). In an embodiment the grains are preferably crystalline. In an embodiment the grains are crystals that essentially consist of molybdenum (Mo), preferably consist of molybdenum (Mo). In an embodiment of the present invention the layers are made up of a series of columnar grains as shown, for example, in Figures 2 and 5A.

The present invention provides a solar cell comprising:
a substrate;
a rear electrode provided on the substrate; wherein the rear electrode comprises n+1 metal columnar grain layers comprising molybdenum (Mo) where 1≤n≤10.

The present invention provides a solar cell of produced by a process comprising the steps of:
depositing a layer of Mo on a substrate,
discontinuing deposition for a time period, optionally where the time period is between 1 second to 3600 seconds,
depositing a second layer of Mo on the first layer.

The present invention also provides a process for producing a solar cell comprising the steps of:
depositing a layer of Mo on a substrate,
discontinuing deposition for a time period, optionally where the time period is between 1 second to 3600 seconds,
depositing a second layer of Mo on the first layer.

As shown in FIG. 2, the rear electrode layer 20 has a multi-layered structure including a plurality of metal columnar grain, preferably crystal grains, layers 20₁-20ₙ₊₁. Here, the number n represents a number of break times included in the metal deposition process during a process for forming the rear electrode layer 20 to be described, and it is an integer defined by 1≤n≤10, optionally 1≤n≤8, 2≤n≤6 or 3≤n≤5. In an embodiment of the present invention, the metal columnar grain layers 20₁-20ₙ₊₁ are each made of molybdenum (Mo), and the metal columnar grain layers 20₁-20ₙ₊₁ are vertically grown with different columnar grain forms so they are identified by existence of a grain boundary at an interface among the metal columnar grain layers 20₁-20ₙ₊₁. In an embodiment of the present invention each layer contains elemental molybdenum (Mo), preferably each layer consists essentially of molybdenum. In a preferred embodiment of the present invention is layer consists essentially of columnar grains of molybdenum (Mo).

In an embodiment of the present invention, the thickness of the metal columnar grain layers 20₁-20ₙ₊₁ can be 20 nm to 500 nm, and in detail, optionally 40 nm to 150 nm, 50 nm to 100 nm or 55 nm to 90 nm. The total thickness of the rear metal layer 20 formed by the plurality of metal columnar grain layers 20₁-20ₙ₊₁ can be 100 nm to 1000 nm, optionally 200 nm to 600 nm or 250 nm to 450 nm.

The interface of the metal columnar grain layers 20₁-20ₙ₊₁ includes oxygen atoms. The amount of oxygen atoms can be 1 atomic % to 70 atomic % of the entire amount of atoms included in the rear metal layer 20, and in detail, optionally, 5 atomic % to 60 atomic %, 10 atomic % to 40 atomic % or 1 atomic % to 20 atomic %. In an embodiment of the present invention, the oxygen atoms are present within oxygen gas. In an embodiment of the present invention the oxygen is trapped at the interface of two adjacent layers of grains, i.e. oxygen gas is trapped between the two layers of columnar grains that preferably consist essentially of molybdenum (Mo).

In an embodiment of the present invention, a light absorbing layer (or a photoelectric converting layer) 30 is provided over the rear electrode layer 20. The light absorbing layer 30 generates electrons and holes by using the light energy transmitted through the transparent electrode layer 50 and the buffer layer 40. In an embodiment of the present invention, the light absorbing layer 30 can include a chalcopyrite compound semiconductor selected from among a group of CulnSe, CulnSe₂, CulnGaSe, and CulnGaSe₂.

In an embodiment of the present invention, the light absorbing layer 30 can be manufactured by a first process of forming a precursor layer by sputtering copper (Cu) and indium (In), or copper (Cu), indium (In), and gallium (Ga), on the rear electrode layer 20, a second process of thermally depositing selenium (Se) on the precursor layer, and a third process of growing CIS (Cu, In, Se) or CIGS (Cu, In, Ga, Se) crystal by performing a fast heat treatment for more than one minute at a high temperature of greater than 550 °C For example, between 550°C and 800°C, optionally between 575°C and 700°C. In this instance, during the fast heat treatment process, part of the selenium (Se) can be exchanged with sulfur (S) so as to prevent evaporation of selenium (Se). In this case, an open voltage of the solar cell 100 can be increased by increasing an energy band gap of the light absorbing layer 30.

In an embodiment of the present invention, the buffer layer 40 can be provided over the light absorbing layer 30. The buffer layer 40 relieves the energy band gap difference between the light absorbing layer 30 and the transparent electrode layer 50. Further, the buffer layer 40 lessens a lattice constant difference between the light absorbing layer 30 and the transparent electrode layer 50 to bond the layers 30 and 50. In an embodiment of the present invention, the buffer layer 40 includes one of cadmium sulfide (CdS), zinc sulfide (ZnS), and indium oxide (In₂O₃). The buffer layer 40 can be omitted depending on the case.

In an embodiment of the present invention, the transparent electrode layer 50 is provided over the buffer layer 40. In an embodiment of the present invention, the transparent electrode layer 50 can be formed with a metal oxide including boron-doped zinc oxide (BZO) with excellent optical transmittivity, zinc oxide (ZnO), indium oxide (In₂O₃), or indium tin oxide (ITO). The transparent electrode layer 50 has great electrical conductivity and optical transmittivity. In an embodiment of the present invention, the transparent electrode layer 50 can have rough surface protrusions and depressions formed through an additional texturing process. In an embodiment of the present invention, also, an antireflection layer (not shown) can be formed over the transparent electrode layer 50. The formation of the surface protrusions and depressions and the antireflection layer on the transparent electrode layer 50 reduces reflection of external light to increase transmission efficiency of sunlight toward the light absorbing layer 30.

In an embodiment of the present invention, the solar cell 100 includes the rear electrode layer 20 including a plurality of metal columnar grain layers 20₁-20ₙ₊₁, and an interface between the metal columnar grain layers 20₁-20ₙ₊₁ includes oxygen atoms so the alkali metal (particularly sodium) from the substrate 10 can be efficiently spread inside the light absorbing layer 30 during the heat treatment for forming the light absorbing layer 30. Further, the solar cell has excellent adherence between the rear electrode layer 20 and the substrate 10.

A method of manufacturing the rear electrode layer 20 of the solar cell 100 according to an embodiment will now be described.

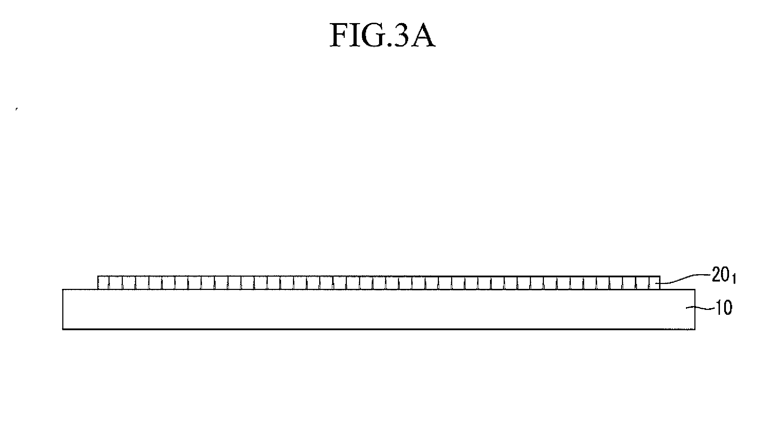

As shown in FIG. 3A, a first metal columnar grain layers 20₁ is formed on the substrate 10. The first metal columnar grain layers 20₁ can be formed by depositing molybdenum (Mo) on the substrate 10 through sputtering. The molybdenum is deposited under a pressure of 0.05 Pa to 5 Pa until the first metal columnar grain layer 20₁ reaches a predetermined thickness.

In an embodiment of the present invention, the layers are deposited under a pressure of 0.05 Pa to 5.0 Pa, optionally 0.10 Pa to 3.5 Pa, optionally 0.20 Pa to 2.5 Pa. In an embodiment of the present invention, the layers are deposited under a vacuum.

The thickness of the first metal columnar grain layer 20₁ is 20 nm to 500 nm, and in detail, optionally 40 nm to 150 nm, 50 nm to 100 nm or 55 nm to 90 nm. A first break time is provided when the first metal columnar grain layer 20₁ is formed. That is, deposition of molybdenum is stopped for a predetermined time. The first break time can be 1 second to 1 hour, optionally for a period of 10 seconds to 600 seconds or 180 seconds to 300 seconds.

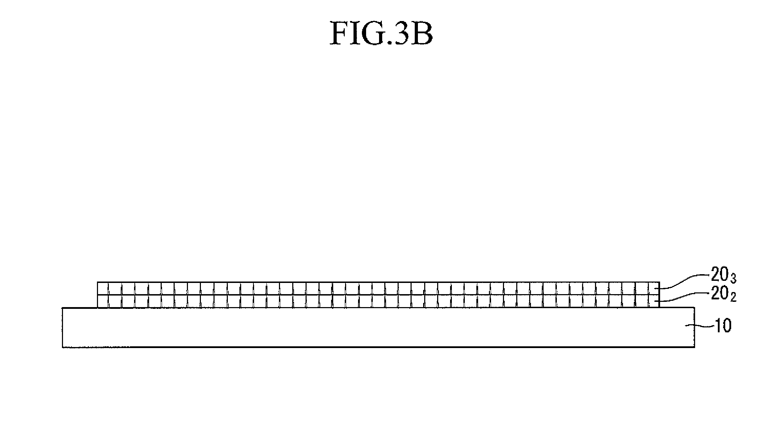

As shown in FIG. 3B, a second metal columnar grain layer 20₂ is formed on the first metal columnar grain layer 20₁. The second metal columnar grain layer 20₂ is deposited under the same conditions as the first metal columnar grain layer 20₁. That is, the process of forming the first metal columnar grain layer 20₁ and the process of forming the second metal columnar grain layer 20₂ are performed in the same chamber and under the same deposition conditions, and the delineation thereof is identified by the first break time. The thickness of the second metal columnar grain layer 20₂ is 20 nm to 500 nm, optionally 40 nm to 150 nm, 50 nm to 100 nm or 55 nm to 90 nm, and it is desirably 50 nm to 100 nm. A second break time is provided when the second metal columnar grain layers 20₂ is formed, That is, deposition of molybdenum is stopped for a predetermined time. The second break time can be 1 second to 1 hour, optionally for a period of 10 seconds to 600 seconds or 180 seconds to 300 seconds,

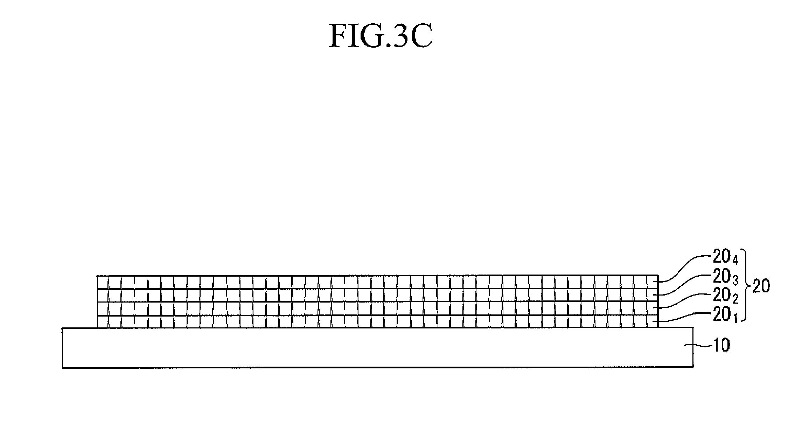

As shown in FIG. 3C, a third metal columnar grain layers 20₃ is additionally formed on the second metal columnar grain layers 20₂. In an embodiment of the present invention, the third metal columnar grain layers 20₃ is also formed in the same chamber and under the same deposition conditions, and it is delineated by the break time between the metal columnar grain layers. The number of metal columnar grain layers 20₁-20ₙ₊₁ is changeable. For example, 2 to 9 layered metal columnar grain layers can be formed with 1 to 8 break times. A fourth metal columnar grain layer 20₄ will be exemplified to be formed in the embodiment. That is, after the second metal columnar grain layer 20₂ is formed, the second break time of a predetermined time is provided and the third metal columnar grain layer 20₃ is then formed. After the third break time of one second to one hour, the fourth metal columnar grain layer 20₄ is formed.

Since the break time is provided between molybdenum deposition, oxygen atoms can be included in the interface between the metal columnar grain layers 20₁-20ₙ₊₁. The amount of included oxygen atoms can be increased or reduced depending on the length of the break time, and the amount of oxygen atoms included in the rear electrode layer 20 depends on the number of interfaces of the metal columnar grain layers 20₁-20ₙ₊₁. For example, the amount of oxygen atoms can be 1 atomic % to 70 atomic % for the molybdenum atoms included in the rear electrode layer 20, and in detail, optionally, 5 atomic % to 60 atomic %, 10 atomic % to 40 atomic % or 1 atomic % to 20 atomic %.

According to the present embodiment, the oxygen atoms can be easily included in the rear electrode layer 20 by providing break times during the process of depositing the molybdenum metal for forming the rear electrode layer 20 without adding a specific process. The alkali metal (particularly sodium) inside the substrate 10 can be efficiently spread into the light absorbing layer 30 by the oxygen atoms included in the rear electrode layer 20 during the heat treatment for manufacturing the solar cell 100. Therefore, the open voltage (Voc) is increased to improve efficiency of the solar cell 100.

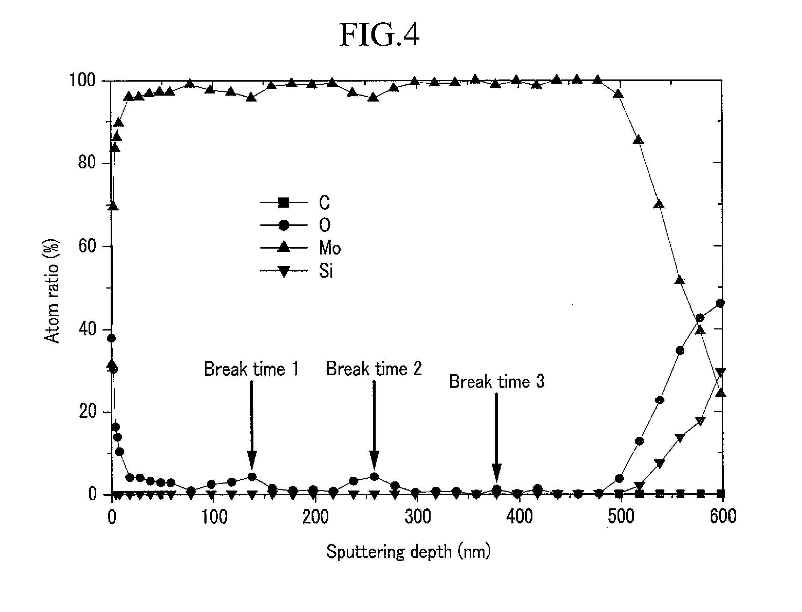

As shown in FIG. 4, it is found that the amount of oxygen atoms is increased during the break times in the process of depositing molybdenum. In the present embodiment, three break times are provided so the oxygen atoms are provided at three time points.

Accordingly, in an embodiment of the present invention, between the formation of each layer there is a independently a break for a period of 1 second to 3600 seconds, optionally for a period of 10 seconds to 600 seconds or 180 seconds to 300 seconds.

In an embodiment of the present invention, the oxygen atoms are introduced by allowing air, oxygen gas, a mixture of oxygen and an inert gas (e.g. nitrogen, argon etc) into the vacuum under which the molybdenum has been deposited.

Further, the molybdenum metal can be deposited at a relatively low pressure. In general, when the molybdenum is deposited through sputtering for forming the rear electrode layer 20, a great pressure is required so as to acquire sufficient adherence with the substrate 10, and in this case, a residual stress characteristic of the rear electrode layer 20 is weakened or resistivity of the rear electrode is increased so the thickness of the electrode must be increased. However, according to the present embodiment, when the molybdenum metal is deposited in the low pressure condition as described, a solar cell 100 with excellent adherence between the rear electrode layer 20 and the substrate 10 can be acquired.

Accordingly, in an embodiment of the present invention, the layers are deposited under a molybdenum (Mo) pressure of 0.05 Pa to 5.0 Pa, optionally 0.10 Pa to 3.5 Pa, optionally 0.20 Pa to 2.5 Pa.

In an embodiment of the present invention the layers are deposited by sputtering. In an embodiment of the present invention the sputtering is carried out a power of between 1.5 kW and 12 kW, optionally 2.0 kW to 10 kW.

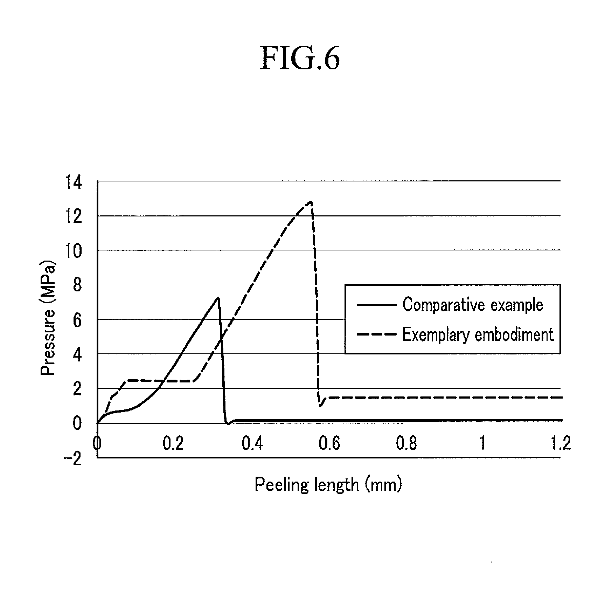

FIG. 5A and 5B show photographs of a cross-section of a rear electrode layer captured by a scanning electron microscope (SEM) according to an embodiment and a comparative example, and FIG. 6 shows a graph of a result of a peel strength test according to an embodiment and a comparative example.

### EXAMPLES

Embodiment 1 represents a case in which three break times are provided when the rear electrode layer 20 is formed, and Comparative Example 1 represents a case in which molybdenum is continuously deposited without a break time to form the rear electrode layer. Regarding Embodiment 1 and Comparative Example 1, molybdenum is deposited under the same conditions except for provision of the break time. That is, the rear electrode layer 20 with the electrode thickness of substantially 300 nm is formed with a pressure of 1.8 Pa and power of 8 kW by using the sputtering method.

As shown in FIG. 5A, in the embodiment with three break times, four metal columnar grain layers (20₁-20₄) are formed on the rear electrode layer 20. In addition, in the case of continuous deposition without a break time as shown in FIG. 5B, a single rear electrode layer 20 is formed without identifying the columnar grain layers. Regarding Embodiment 1 and Comparative Example 1, peel strengths are estimated. FIG. 6 shows a graph of results of a peel strength test according to an embodiment and a comparative example. Regarding the rear electrode layer 20 of embodiment 1 and Comparative Example 1, pressure is applied in the thickness direction of the rear electrode layer 20 to estimate the peeling point. As shown in FIG. 6, the peeling point in Embodiment 1 represents a point when the pressure of 13 MPa is applied, which shows excellent peel strength compared to Comparative Example 1 indicating peeling with a pressure of substantially 7 MPa.

Further, tape assessments were performed for Embodiments 2, 3, 4, and 5 and Comparative Examples 2, 3, 4, and 5. Regarding Embodiments 2, 3, 4, and 5, the deposition conditions are different and the rear electrode layer 20 is formed under the condition of three break times. Regarding Comparative Examples 2, 3, 4, and 5, the rear electrode layer is formed with continuous deposition without a break time under the same deposition conditions as embodiments 2, 3, 4, and .5

The tape assessments are tested for Embodiments 2, 3, 4, and 5 and Comparative Examples 2, 3, 4, and 5. That is, when a commercial 3M tape is attached to and detached from the surface of the finished rear electrode layer 20, it is determined to fail (marked with X) when a part of the rear electrode layer 20 is detached, and it is determined to pass (marked with O) when no part of the rear electrode layer 20 is detached. Table 1 shows deposition conditions and tape test results of Embodiments 2, 3, 4, and 5 and Comparative Examples 2, 3, 4, and 5.

**(Table 1)**

| | Sputtering pressure (Pa) | Sputtering power (kW) | Number of break times | Total thickness (nm) | Tape test result |
|---|---|---|---|---|---|
| Embodiment 2 | 0.3 | 3 | 3 | 300 nm | O |
| Comparative Example 2 | | | 0 | | X |
| Embodiment 3 | 2 | 3 | 3 | | O |
| Comparative Example 3 | | | 0 | | X |
| Embodiment 4 | 0.3 | 8 | 3 | | O |
| Comparative Example 4 | | | 0 | | X |
| Embodiment 5 | 2 | 8 | 3 | | O |
| Comparative | | | 0 | | X |
| Example 5 | | | | | |

As expressed in Table 1, Embodiments 2 to 5 show excellent peel strengths irrespective of sputtering conditions. That is, according to Embodiments 2 to 5, excellent adherence between the rear electrode layer 20 and the substrate 10 is acquired under the conditions of low sputtering pressure and high sputtering power

While preferred embodiments have been described, it is to be understood that the invention is not limited thereto, but is intended to cover various modifications and equivalent arrangements included within the scope of the appended claims, description, and drawings.

## Claims

1. A solar cell comprising:
a substrate;
a rear electrode provided on the substrate; wherein the rear electrode comprises n+1 metal columnar grain layers comprising molybdenum (Mo)where 1≤n≤10.

2. The solar cell of claim 1 where n is 1≤n≤8, optionally 2≤n≤6 or 3≤n≤5.

3. The solar cell of claim 1 or claim 2, wherein the layers are each independently between 20 nm to 500 nm in thickness, optionally 40 nm to 150 nm, 50 to 100 nm or 55 nm to 90 nm.

4. The solar cell of any of claims 1 to 3, wherein rear electrode is between 100 nm to 1000 nm in thickness, optionally 200 nm to 600 nm or 250 nm to 450 nm.

5. The solar cell of any of claims 1 to 4, wherein oxygen is present at least one interface between layers, optionally the amount of oxygen atoms is 1 atomic % to 70 atomic % of the entire amount of atoms included in the rear electrode, optionally, 5 atomic % to 60 atomic %, 10 atomic % to 40 atomic % or 1 atomic % to 20 atomic %.

6. The solar cell of any of claims 1 to 5, wherein solar cell also contains at least one of a light absorbing layer, a buffer layer and a transparent electrode layer.

7. The solar cell of claim 6 wherein CIS (Cu, In, Se) or CIGS (Cu, In, Ga, Se) are present in the light absorbing layer.

8. The solar cell of any of claims 1 to 7, wherein the solar cell is produced by a process comprising the steps of:
depositing a layer of Mo on a substrate,
discontinuing deposition for a time period, optionally where the time period is between 1 second to 3600 seconds,
depositing a second layer of Mo on the first layer.

9. The solar cell of claim 8, wherein the layers are deposited by sputtering.

10. The solar cell of claims 8 or 9, wherein the layers are deposited under a pressure of 0.05 Pa to 5.0 Pa, optionally 0.10 Pa to 3.5 Pa, and optionally 0.20 Pa to 2.5 Pa.

11. The solar cell of any of claims 8 to 10, wherein between the formation of each layer there is a break for a period of 1 second to 3600 seconds, optionally for a period of 10 seconds to 600 seconds or 180 seconds to 300 seconds.

12. The solar cell of any of claims 9 to 11, wherein the sputtering is carried out a power of between 1.5 kW and 12 kW, optionally 2.0 kW to 10 kW.

13. A process as defined in any of claims 8 to 12 for preparing a solar cell.
